# FASCICULE DE BREVET EUROPEEN

(11) **EP 0 710 433 B1**
(45) Date de publication et mention de la délivrance du brevet: **09.04.1997**
(21) Numéro de dépôt: 94922931.4
(22) Date de dépôt: 18.07.1994
(51) Int. Cl.: H05K 3/10, G02F 1/1343, H01J 17/04, G02B 1/10, H05B 3/86

(54) **CIRCUITS ELECTRIQUES A TRES HAUTE CONDUCTIBILITE ET DE GRANDE FINESSE, LEURS PROCEDES DE FABRICATION, ET DISPOSITIFS LES COMPRENANT**
SEHR HOCHLEITFÄHIGE UND SEHR FEINE ELEKTRISCHE SCHALTUNGEN, VERFAHREN ZUR HERSTELLUNG UND DIESE ENTHALTENDE ANORDNUNGEN
ELECTRICAL CIRCUITS WITH VERY HIGH CONDUCTIVITY AND GREAT FINENESS, METHODS OF MANUFACTURE AND DEVICES COMPRISING SAME

(30) Priorité: 19.07.1993 FR 9308836
(43) Date de publication de la demande: 08.05.1996
(73) Titulaire: COMPAGNIE GENERALE D'INNOVATION ET DE DEVELOPPEMENT COGIDEV, F-92500 Rueil-Malmaison (FR)
(72) Inventeur: GIRAUD, André, F-92300 Levallois-Perret (FR); FREMAUX, Jacques, F-61380 Bonsmoulins (FR)
(74) Mandataire: Chaillot, Geneviève
(86) Numéro de dépôt international: FR9400893
(87) Numéro de publication internationale: WO9503684

(56) Documents cités:
- GB-A- 2 054 259
- US-A- 3 942 061
- US-A- 4 352 040
- US-A- 5 163 220
- PATENT ABSTRACTS OF JAPAN vol. 017, no. 234 (E-1362) 12 Mai 1993 & JP-A-04 363 092
- PATENT ABSTRACTS OF JAPAN vol. 14, no. 273 (E-940) (4216) 13 Juin 1990 & JP-A-02 086 189
- IBM TECHNICAL DISCLOSURE BULLETIN., vol.18, no.5, Octobre 1975, NEW YORK US pages 1527 - 1528 L. BERENBAUM 'Processing technique for gas discharge panels'

## Description

La présente invention porte sur des circuits électriques à très haute conductibilité et de grande finesse, ainsi que sur des procédés permettant de les fabriquer. Par conductibilité, on entend essentiellement la conductibilité électrique, mais les circuits réalisés selon la présente invention peuvent, le cas échéant, être employés pour leur conductibilité thermique en participant au transport de calories.

L'invention porte également sur les dispositifs comportant de tels circuits, comme les dispositifs électrochromiques, à commande matricielle ou à segments, pour la modulation de la lumière, tels que les dispositifs pour la réflexion variable ou la transmission variable de la lumière, l'affichage de signaux et images, par exemple, d'informations alpha-numériques ou graphiques, ainsi que les dispositifs d'affichage électroluminescents ou à cristaux liquides ; les vitrages à propriétés optiques variables (fenêtres, écrans, pare-brise), valves, lunettes à transparence variable, miroirs à réflexion variable ; les dispositifs de chauffage électrique à courant de puissance (radiateurs ou convecteurs, panneaux radiants) ; et les circuits électroniques de puissance, par exemple les circuits de sortie d'amplificateurs. Dans ces dispositifs, les circuits électriques doivent souvent être très fins pour pouvoir être transparents et/ou à grande densité d'éléments conducteurs sur une surface donnée.

A l'heure actuelle, la fabrication de tels circuits électriques s'effectue par une grande diversité de procédés dont les plus connus sont :
(a) la gravure, par exemple par attaque acide, de couches conductrices (par exemple de cuivre), déposées sur des supports non conducteurs, tels que des feuilles de matière plastique, renforcées ou non de fibres, ou des plaques de verre ;
(b) le dépôt, par des procédés d'impression appropriés, sur des supports non conducteurs variés, de pistes conductrices, constituées d'encres ou pâtes conductrices, ces pistes correspondant au dessin du circuit ;
(c) le dépôt, par des procédés divers de projection ou de dépôt en phase vapeur, d'une couche conductrice sur une surface sur laquelle a été préalablement déposé un masque; le masque cache les zones de la surface non conductrice sur laquelle on ne souhaite pas voir la couche conductrice se déposer, et le circuit apparaît après enlèvement du masque par un procédé adéquat, par exemple d'attaque chimique : un procédé de cette catégorie, la photolithographie, est utilisé notamment pour la fabrication des circuits très fins.

Cependant, ces procédés connus ne permettent pas de remplir simultanément plusieurs conditions nécessaires à la réalisation de certains circuits électriques. Par exemple, la photolithographie, qui permet de réaliser des circuits présentant une épaisseur très faible et d'une très grande finesse, ne permet pas d'obtenir simultanément une conduction linéaire élevée pour les conducteurs du circuit, du fait même de leur très faible épaisseur. D'autres procédés, tels que les procédés d'impression (sérigraphie, offset, etc.), ne permettent pas d'obtenir une finesse suffisante des lignes imprimées et, plus encore, une séparation très fine des lignes conductrices par rapport à leurs voisines. Cette difficulté s'accroît encore si l'on souhaite revêtir la zone conductrice d'une couche destinée à la protéger du contact avec un milieu corrosif ou conducteur qui pourrait l'attaquer ou le mettre en court-circuit. Pour déposer le conducteur, puis le recouvrir d'une ou de plusieurs couches protectrices, il faut procéder en plusieurs passes successives, parfaitement positionnées les unes par rapport aux autres et il est encore plus difficile d'obtenir la finesse désirée.

Dans certains cas, on veut obtenir à la fois une excellente conductivité linéaire, une surface de rugosité voisine de zéro après installation du circuit et une protection de celui-ci. Cet objectif n'est pas à la portée des procédés d'impression qui, pour obtenir une conduction élevée, doivent déposer une couche épaisse, laquelle fait alors un relief inacceptable à la surface du support.

Certaines conditions supplémentaires sont parfois demandées, qui accroissent encore la difficulté du problème : par exemple réaliser des circuits de grande dimension (pratiquement inaccessible à la photolithographie) ou encore assurer le contact entre le circuit déposé et une couche conductrice très mince avoisinante, pour assurer, par exemple, l'uniformité du potentiel électrique le long des colonnes (ou des lignes) qui participent au fonctionnement matriciel des écrans plats de visualisation.

Les colonnes (ou lignes) de ces écrans servent à introduire des données nécessaires pour la commande et l'apport d'information affectant les pixels situés le long de chaque colonne. Ces colonnes sont réalisées à la surface d'une plaque de verre par des bandes conductrices résultant d'un dépôt de métal ou d'oxyde, qui, pour être transparent, doit être très peu épais (généralement moins d'un micron) et est, par conséquent, très peu conducteur. Ainsi, pour un afficheur ayant seulement 3 cm de largeur, on obtient, pour une colonne d'oxyde d'étain et d'indium (ITO) de 500 microns de largeur, une résistance de 300 ohms, ce qui est inacceptable dans le cas de dispositifs utilisant des appels de courants importants (quelques A au dm²). En effet, cette faible conductivité entraîne, le long de la colonne, une forte chute de potentiel qui peut créer de sérieux problèmes si l'écran est de grande dimension : le fonctionnement des pixels au centre devient très différent de celui des pixels situés à la périphérie. On est donc amené à installer, le long de la colonne transparente, une fine ligne épaisse conductrice opaque, située dans l'intervalle noir ("black matrix") entre les pixels, et en contact tout du long avec la colonne dont elle renforce la conduction. Mais on rencontre alors une autre difficulté. En effet, la fabrication de l'écran avec certains procédés, tels que ceux qui emploient des cristaux liquides utilisant certains effets (nématique twisté et dérivés - STN -, smectique A, smectique C*, ferroélectrique,...) implique une grande régularité de l'interface entre les électrodes. Ainsi, dans le cas des dispositifs d'affichage à cristaux liquides (LCD), l'espace doit être de 5 microns à ± 0,2 micron près et même de l'ordre du micron pour les cristaux liquides ferroélectriques. Ceci est incompatible avec la réalisation des renforts de conductivité par des dépôts à la surface du verre qui ne peuvent être larges pour être invisibles et devraient être en relief pour être conducteurs.

En outre, pour quelques procédés, certains électrochromes par exemple, la couche interposée entre les électrodes présente des propriétés corrosives, ce qui oblige à réaliser les renforts de conductivité d'une façon telle qu'ils soient en communication électrique avec la couche conductrice transparente, tout en étant protégés de la corrosion due à la couche luminophore.

La description de ce problème illustre sa complexité et sa difficulté à laquelle s'ajoute en outre la nécessité d'employer un procédé commode et rapide pour atteindre les meilleurs prix de revient.

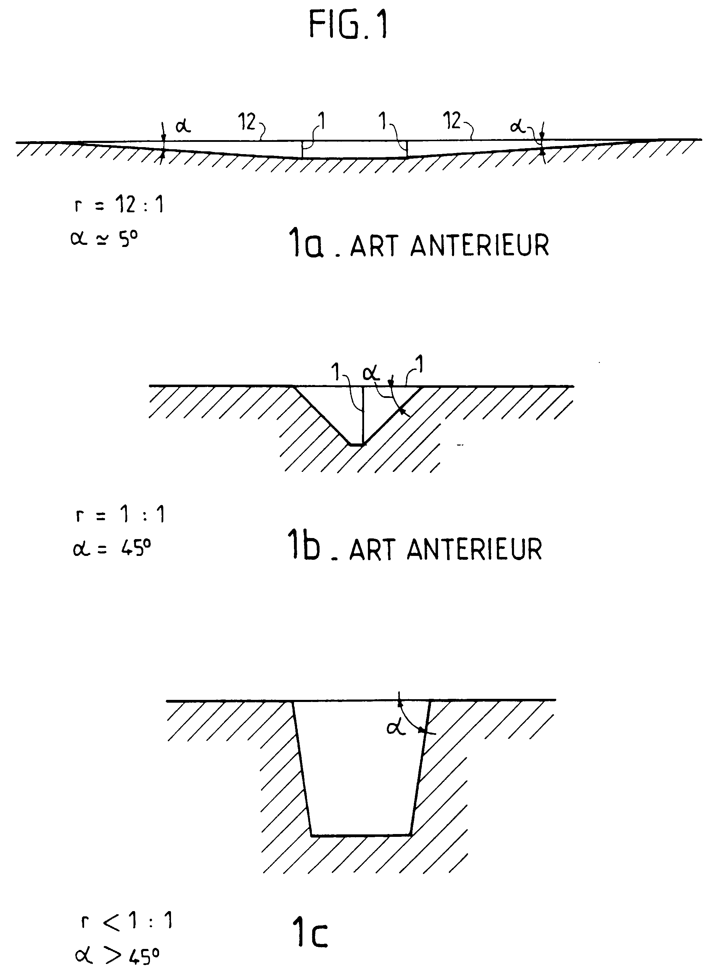

On connaît certes, par le brevet américain US-A-5 163 220, un procédé pour rehausser la conductivité électrique de bandes d'électrodes d'ITO dans des panneaux d'affichage électroluminescents à film mince (TFEL). Conformément à ce procédé, on crée des sillons dans le support d'électrodes par gravure chimique (à l'aide d'une solution de HF et de fluorure d'ammonium) et on remplit ces sillons par pulvérisation cathodique de couches successives de titane, d'argent, puis de titane (couche barrière). La gravure chimique est conduite après un chauffage de la plaque, permettant de rendre les sillons moins ouverts, l'inclinaison α des parois latérales passant de moins de 5° à la valeur limite de 45° (autrement dit, comme indiqué sur les Figures 1a et 1b, le rapport r de gravure latérale à verticale passant d'environ 12:1 à 1:1). Avec la technique de gravure décrite, la profondeur des sillons ne dépasse pas 1 µm en pratique. Le remplissage des sillons s'effectue par pulvérisation cathodique, ce qui ne permet de déposer que des couches très minces. Les bandes d'ITO sont ensuite déposées pour recouvrir les sillons.

La faible profondeur des sillons et la faible épaisseur des couches pratiquement réalisables par pulvérisation cathodique font qu'avec le procédé décrit dans ce brevet américain, on ne parvient qu'à des conductivités limitées.

L'objectif de la présente invention est de proposer une solution pour permettre de réaliser, sur des supports en une matière isolante, telle que le verre minéral ou organique, des circuits à très haute conductibilité, notamment des circuits comportant des lignes très fines ou des lignes séparées par des lignes isolantes très fines, pouvant avantageusement être protégés chimiquement des attaques éventuelles d'éléments corrosifs, et dont la transparence n'est sensiblement pas affectée par le renfort de conductivité.

A cet effet, il est proposé, conformément à la présente invention, de creuser des sillons de profondeur relativement importante, avantageusement délimités par des parois latérales abruptes. On peut alors disposer de profils de remplissage de relativement grande section, permettant ainsi de fortes conductivités. En outre, ce remplissage est obtenu par des techniques beaucoup plus aisées à mettre en oeuvre que la pulvérisation cathodique, telles que l'application de pâtes, poudres, etc., permettant d'installer des combinaisons très variées de couches conductrices et/ou protectrices, relativement épaisses, et/ou de fils conducteurs, et donc un ajustement de la conductibilité en fonction de l'environnement du circuit, et permettant aussi des combinaisons diverses de ces remplissages avec une couche mince définissant le circuit, assurant des meilleurs contacts avec cette couche mince.

La présente invention a donc d'abord pour objet un circuit électrique à très haute conductibilité et de grande finesse, destiné notamment à entrer dans la constitution de dispositifs de modulation de la lumière ou d'affichage de différentes sortes tels qu'électroluminescents, électrochromiques ou à cristaux liquides, de vitrages et valves à propriétés optiques variables, de dispositifs de chauffage électrique à courant de puissance et de circuits électroniques de puissance, ledit circuit comportant :
- un support en une matière isolante ;
- recouvert, sur au moins une partie de sa surface, par une fine couche conductrice, dont la forme géométrique correspond au schéma choisi pour le circuit électrique ;
- ladite couche conductrice étant parcourue par un ou plusieurs sillons très fins gravés dans le support, d'une profondeur supérieure à 1 µm ;
- ledit (ou lesdits) sillon(s) étant entièrement rempli(s) par au moins deux composants superposés :
   . le(s) premier(s), situé(s) au fond du sillon, constitué(s) par un matériau fortement conducteur, à savoir soit un fil conducteur ou un profilé conducteur, soit une substance conductrice obtenue par traitement d'un matériau précurseur liquide, pulvérulent ou pâteux, mis en place au préalable dans le sillon, ledit traitement ayant donné audit matériau précurseur sa consistance dure et ses propriétés définitives ;
   . le dernier, assurant le rebouchage du sillon, obtenu par traitement d'un matériau précurseur liquide, pulvérulent ou pâteux, conducteur ou non, ledit traitement ayant donné audit matériau précurseur sa consistance dure et ses propriétés définitives ;
- la couche conductrice étant déposée de telle sorte qu'elle soit en contact avec le(s) composant(s) conducteur(s) placé(s) dans le sillon, soit avant remplissage, soit à un stade intermédiaire, soit après rebouchage du sillon.

Par "fine couche conductrice", on entend une couche dont l'épaisseur va généralement de 0,05 µm à 0,6 µm.

Conformément à une caractéristique tout particulièrement préférée, le rapport r de gravure latérale à verticale du ou des sillons est inférieur à 1:1 (parois latérales inclinées de plus de 45°, comme illustré sur la Figure 1c).

Par "sillons très fins", on entend des sillons ayant une largeur moyenne généralement comprise entre environ 15 et 80 µm, sans que ces dimensions puissent être considérées comme critiques. Par ailleurs, de façon générale, la profondeur des sillons est supérieure à 6 µm, étant notamment supérieure à 15 µm, pouvant aller jusqu'à 100 µm.

On peut ici souligner que la présente invention, qui permet de réaliser des sillons de plusieurs dizaines de µm de profondeur et des remplissages également de plusieurs dizaines de µm, permet des renforcements de conductivité de la couche conductrice fine placée sur le support, plusieurs centaines de fois plus importants que dans le cas du brevet américain précité US-A-5 163 220.

Le support peut présenter diverses formes, et les sillons peuvent être disposés selon les arrangements les plus divers. On peut citer, entre autres, le cas d'un support plat et de sillons rectilignes disposés parallèlement entre eux et coopérant avec une couche conductrice revêtant le support, continue ou sous forme de bandes parallèles aux sillons, au moins un sillon pouvant être associé à une bande. On peut également citer les circuits permettant de transporter du courant à des gros pixels découpés dans une couche conductrice, ou encore pour d'autres applications électroniques où l'on cherche à avoir une forte densité de courant sur certaines parties de la surface du support.

Les fils conducteurs peuvent comporter un enrobage protecteur, conducteur, ledit enrobage pouvant également avoir subi, une fois le fil mis en place, un traitement le consolidant et lui donnant ses propriétés définitives.

Les matériaux précurseurs des substances conductrices sont décrits plus loin avec référence aux procédés selon l'invention. On notera que le matériau précurseur utilisé pour constituer la couche de rebouchage du sillon, peut être plus faiblement conducteur, voire non conducteur, auquel cas le contact entre la couche fine conductrice et le remplissage du sillon s'effectue au niveau des couches conductrices du sillon.

On peut également envisager le cas où les différentes couches de remplissage du sillon sont constituées à partir du même matériau précurseur, auquel cas il pourrait être impossible de les distinguer une fois conduits les traitements plaçant ces matériaux dans leur forme finale.

La partie conductrice du circuit selon l'invention est donc constituée par au moins une substance conductrice installée dans le ou les sillons sans former de relief à la surface du support, et par une couche conductrice continue ou discontinue, déposée sur le support, le ou les conducteurs remplissant le ou les sillons étant disposés pour constituer des moyens d'amenée de courant supplémentaire à la couche conductrice, des moyens étant prévus pour assurer la communication électrique entre ladite couche et ces moyens d'amenée de courant supplémentaire.

Dans ce dernier cas, les moyens assurant la communication électrique entre la couche conductrice et les moyens d'amenée de courant supplémentaire peuvent être constitués par un prolongement de ladite couche conductrice sur la paroi intérieure du sillon, au sein de la partie conductrice se trouvant dans le sillon, ou sur la surface supérieure de ladite partie conductrice se trouvant dans le sillon, ou encore par des bandes conductrices disposées de façon à chevaucher la couche conductrice et la surface supérieure de la partie conductrice se trouvant dans le sillon. Si la couche conductrice est discontinue, la discontinuité peut être créée par un dépôt de la couche en parties discontinues ou par des rainures ou des gorges pratiquées dans le support, à travers ladite couche ou à cheval sur l'une des bordures supérieures des sillons, de façon à exposer la matière isolante constituant le support, lesdites rainures ou gorges pouvant être remplies par une matière non conductrice reconstituant la continuité de surface dudit support.

La présente invention a également pour objet un procédé de fabrication d'un circuit électrique tel que défini ci-dessus, caractérisé par le fait que :
- on creuse, à la surface d'un support en matière isolante, le cas échéant revêtu par une couche conductrice mince, le ou les sillons en fonction du schéma de circuit choisi, une couche mince de matière conductrice étant ensuite déposée sur des parties ou sur la totalité de la surface du support, y compris des sillons, dans le cas où ledit support n'était pas préalablement revêtu ;
- on assure le remplissage des sillons par l'introduction d'au moins une couche de matériau précurseur de couche conductrice, pulvérulent ou de consistance liquide à pâteuse, approprié pour pouvoir être installé dans lesdits sillons et/ou par le positionnement direct d'un fil conducteur, éventuellement doté d'un enrobage conducteur, ou d'un profilé conducteur, en terminant le cas échéant le remplissage par une couche de matériau pulvérulent ou de consistance liquide à pâteuse, précurseur de couche protectrice, conductrice ou non, neutre vis-à-vis de son environnement ;
- après mise en place d'au moins un matériau précurseur, on conduit un traitement approprié de ce dernier pour lui donner ses forme, consistance et propriétés définitives, une couche mince de matière conductrice pouvant, dans le cas d'un support préalablement revêtu, être déposée au cours du remplissage des sillons, sur des parties ou sur la totalité du support, y compris des sillons, entre deux couches de remplissage de ceux-ci, ou bien être déposée après le remplissage des sillons sur des parties ou sur la totalité du support ; et
- dans le cas où la couche mince externe doit être discontinue, on forme des rainures ou gorges, de façon à exposer le support en matière isolante, selon le schéma de circuit choisi, les rainures ou gorges pouvant ensuite être remplies par une matière non conductrice.

Pour graver, sur la surface du support, des sillons abrupts conformes à la présente invention, on peut employer un procédé thermique, mécanico-thermique, mécanique, mécanico-chimique, ou électrique.
(1) Comme procédé thermique, on cite l'emploi d'un laser, par exemple d'un laser excimer UV. Cette méthode présente l'avantage de permettre la gravure de circuits étendus et complexes, avec un minimum de manipulations des supports et avec une grande vitesse de production. On peut ainsi obtenir des sillons très fins, positionnés avec une grande précision et avec un profil très propre.
(2) Comme procédés mécanico-thermiques, on peut citer le pressage, l'injection et le refoulage. Dans le cas du pressage, une goutte de verre (paraison), délivrée à partir d'un dispositif d'alimentation, tombe, en chute libre sur le fond d'un moule, puis un poinçon comportant des arêtes destinées à constituer les sillons, vient presser la goutte de verre en gravant dans le verre mou l'empreinte du poinçon. Dans le cas de l'injection, une goutte de verre est reçue dans un piston qui injecte, par un effet de pression, le verre dans un moule fermé. Et dans le cas du refoulage, une plaque de verre, de la dimension finale, est préchauffée légèrement au-dessus du point de ramollissement, puis est introduite dans une pression laquelle matrice la gravure.
(3) Les procédés mécaniques sont le sablage, le rodage et le meulage. Dans ce dernier cas, on utilise une meule ou scie circulaire. Les progrès, faits au cours des dernières années dans ce domaine et dans les machines correspondantes, permettent parfaitement d'obtenir la précision et la finesse nécessaires et d'éviter de briser les supports.
(4) Parmi les procédés mécanico-chimiques, on peut citer le jet d'eau haute pression, ou l'usinage par ultrasons.
(5) Comme procédé électrique, on peut mentionner l'érosion qui est provoquée par le contact du verre avec un fil de platine porté au rouge par effet Joule. Ce procédé est connu sous le nom de Planté et une variante de celui-ci sous le nom de Phelps (cf. Nouveau Manuel Complet du Verrier, Julia de Fontenelle et F. Malepeyre, Tome II, pages 41-43).

On installe avantageusement les couches successives de matériau précurseur par application d'une substance pulvérulente ou de consistance liquide à pâteuse du matériau précurseur sur la surface du support portant les sillons et retrait de la substance n'ayant pas pénétré dans ceux-ci ou application d'une pâte ou encre à la raclette ou à l'aide d'une roulette d'encrage, un traitement destiné à rendre non mouillable par l'encre la surface du support ayant pu avoir été réalisé, préalablement à la formation des sillons, pour que l'encre appliquée se réfugie sensiblement exclusivement dans les sillons.

A titre d'exemple, on peut mentionner l'utilisation d'une poudre métallique, telle qu'une poudre de zinc, d'étain, d'argent, etc., que l'on place sous la forme d'une pâte à l'eau, en la mélangeant avec la quantité d'eau juste nécessaire pour remplir les vides entre les grains (on emploie des grains de diamètre sensiblement inférieur à la largeur et à la profondeur des sillons). Ces pâtes ont notamment la viscosité d'une pâte dentifrice et peuvent être installées dans les sillons à l'aide d'un simple chiffon ou d'une roulette d'encrage.

On peut également citer l'emploi d'une encre, telle qu'une encre adaptée pour la sérigraphie, par exemple la technologie des "hybrides couches épaisses". De telles encres sont, par exemple, des encres vinyliques, phénoliques ou époxy, à base d'argent, de cuivre, d'or, etc., dont la viscosité a été ajustée afin de les rendre sérigraphiables. On peut les installer commodément dans les sillons en utilisant une raclette comme dans la sérigraphie.

On peut également installer dans les sillons des fils métalliques, par exemple des fils de cuivre, dont le diamètre est inférieur à la profondeur du sillon. Cette opération, relativement délicate, s'effectue mieux si le fil est enduit d'une fine couche protectrice, par exemple de polymère thermoplastique ou thermodurcissable. Comme le fil a besoin d'être en contact électrique avec l'extérieur, le polymère est chargé de poudre, par exemple, du graphite ou carbone conducteur pour devenir lui-même conducteur. Une couche complémentaire, par exemple du même polymère éventuellement conducteur, est ajoutée pour finir de remplir le sillon. Si besoin est, un léger polissage permet de retrouver une surface unie.

Enfin, on donne au matériau précurseur installé dans un sillon sa forme et/ou structure définitive par fusion reconstituant l'analogue d'un fil métallique, par un traitement thermique, par micro-ondes ou infrarouges, dans le cas d'une poudre métallique ou d'une poudre métallique placée sous la forme de pâte à l'eau ou d'encre conductrice ; par séchage dans le cas d'une pâte ou encre de type pour emploi dans la sérigraphie ou du type chargée au carbone ou d'une colle conductrice, en vue de l'évaporation de l'eau ou du solvant qui y est contenu ; par polymérisation ou durcissement dans le cas de compositions polymérisables ou de compositions de polymères thermodurcissables.

Dans le cas où l'on emploie une poudre métallique, telle quelle ou sous la forme d'un pâte à l'eau, la fusion permet de reconstituer un véritable fil métallique bénéficiant de la conductivité correspondante. Cette fusion est avantageusement réalisée sous atmosphère réductrice, par exemple de N₂ + 5% en volume de H₂. De la même façon, un traitement dans un four à micro-ondes d'une encre conductrice à base de poudre métallique (cuivre par exemple) permet de réaliser le conducteur après remplissage des sillons.

Si l'on a utilisé une pâte ou encre métallique de type de celle développée pour emploi dans la sérigraphie, on peut conduire un séchage de façon à obtenir une couche dure, dont la conductivité est cependant inférieure à celle du métal plein, mais peut suffire dans de nombreux cas.

On peut également utiliser, par la même technique, des encres polymériques chargées au carbone ou des colles conductrices ou des compositions polymériques chargées de poudres métalliques, ayant l'avantage, même si elles sont un peu moins conductrices, d'être passives vis-à-vis de toute agression physico-chimique. Elles peuvent du reste être utilisées en particulier pour protéger les conducteurs créés par les autres méthodes indiquées.

Il est également possible de réaliser l'une des couches de remplissage par dépôt chimique ou dépôt électrolytique. Par exemple, on peut rendre le fond des sillons conducteurs par précipitation chimique, étamage, argenture, dorure, platinage, cuivrage, etc., et utiliser éventuellement ce dépôt comme électrode de départ pour faire croître une couche plus épaisse, de cuivre par exemple, par galvanoplastie. On peut éventuellement déposer en outre des couches fines, par exemple de SnO₂ ou ITO, par pulvérisation cathodique ou par un procédé CVD. Ceci n'est cependant pas préféré, car ces techniques ne permettent de métalliser que sur quelques centaines de nanomètres, alors que les sillons selon l'invention ont une profondeur supérieure à 1 micron.

Enfin, la présente invention porte également sur les dispositifs comportant les circuits tels qu'ils viennent d'être décrits.

On peut mentionner un dispositif pour la modulation de la lumière, tel qu'un dispositif électrochromique pour la modulation de la lumière, un dispositif d'affichage à cristaux liquides et des autres types précités, un vitrage ou une valve à propriétés optiques variables, comportant deux supports portant, l'un, un circuit d'électrodes, et l'autre, un circuit de contre-électrodes, les deux circuits étant disposés en regard avec interposition d'une couche luminophore, au moins l'un des deux circuits d'électrodes étant alors tel que défini ci-dessus. Comme dispositifs de ce type, illustrés ci-après, on peut citer les écrans ou afficheurs composés de cellules commandées selon un mode matriciel, les circuits d'électrodes et de contre-électrodes étant constitués respectivement de colonnes parallèles conductrices et de lignes parallèles conductrices, disposées perpendiculairement par rapport aux colonnes, au moins le circuit des électrodes étant alors conforme à l'invention. On peut citer aussi les vitrages ou valves à propriétés variables, également illustrés ci-après, dont les deux circuits sont conformes à l'invention, des moyens pouvant être prévus pour assurer une commande indépendante du potentiel des parties conductrices de chaque sillon et, le cas échéant, de la couche conductrice externe associée à celui-ci, dans le cas où cette couche est discontinue.

Pour illustrer davantage l'objet de la présente invention, on va en décrire ci-après, à titre indicatif et non limitatif, plusieurs modes de réalisation en liaison avec le dessin annexé.

Sur ce dessin :
- la Figure 1, à laquelle il a été fait référence ci-dessus, représente, de façon schématique, des profils de sillon selon l'art antérieur et selon l'invention ;
- la Figure 2 est une vue schématique partielle, en coupe transversale, à échelle agrandie, d'un écran matriciel électrochrome, dont le circuit d'électrodes constituant les colonnes de l'écran est réalisé conformément à la présente invention ;
- les Figures 3 à 6 illustrent chacune un procédé de fabrication d'une variante de réalisation de ce circuit d'électrodes, montrant, dans chaque cas, les étapes successives de formation des colonnes sur une partie de la plaque de base, représentée à une échelle encore plus grande ;
- les Figures 7 à 9 représentent chacune, en coupe transversale, une autre variante possible de réalisation de la partie conductrice remplissant un sillon de ce circuit d'électrodes ;
- la Figure 10 est une vue schématique d'un élément de panneau d'affichage à adressage direct comportant un circuit électrique conforme à la présente invention ; et
- les Figures 11 et 12 représentent chacune une vue schématique partielle, en coupe transversale, à échelle agrandie, d'un vitrage à propriétés optiques variables et commandables, comportant des circuits d'électrodes conformes à la présente invention.

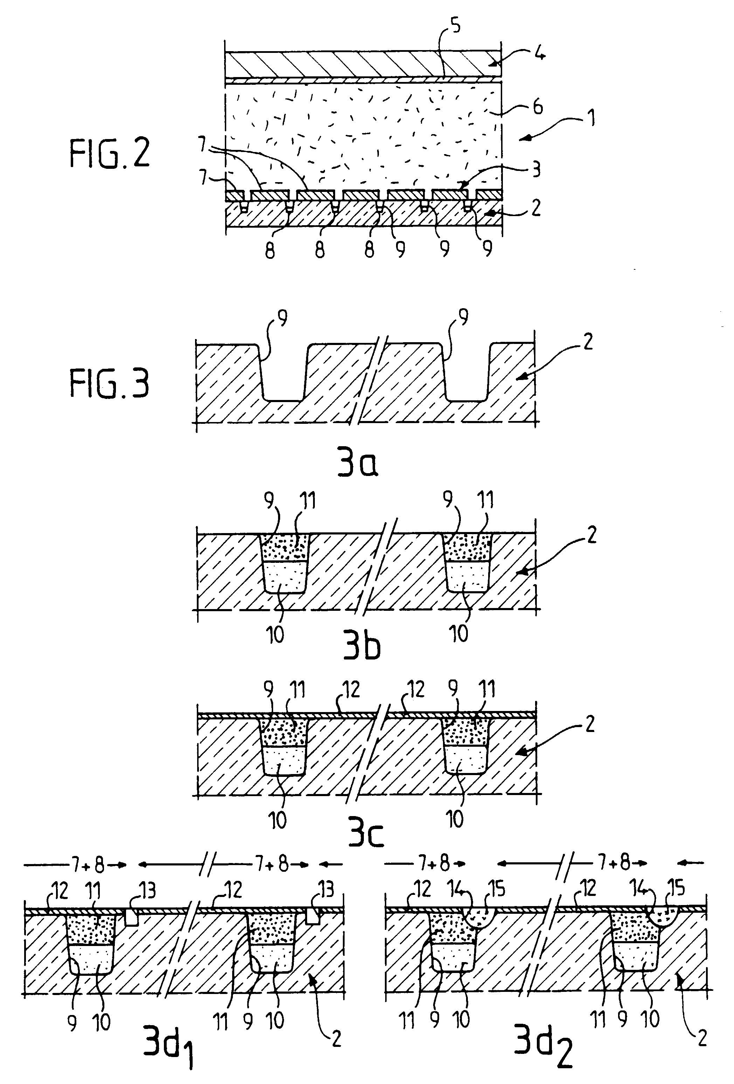

Si l'on se réfère tout d'abord à la Figure 2, on voit que l'on a représenté un écran matriciel électrochrome 1, de structure connue, qui comporte une première plaque-support 2, transparente, portant des électrodes de travail 3, transparentes, et une seconde plaque-support 4, écartée transversalement par rapport à la plaque 2 et portant des contre-électrodes 5, la plaque 4 et les contre-électrodes 5 pouvant être en matière transparente, au moins une couche 6 de matériau électrolytique, dont la composition permet d'assurer l'électrochromisme (matériau luminophore ou chromogène), étant disposée entre les électrodes 3 et les contre-électrodes 5.

La plaque transparente est en verre minéral ou en verre organique. Parmi les verres organiques, on peut citer notamment le poly(méthacrylate de méthyle), les polycarbonates, des aminoplastes, des résines allyliques ; on peut également citer les polyesters et les polyuréthanes.

Les électrodes 3 se présentent sous la forme de bandes conductrices 7, appelées aussi "colonnes" de l'écran, transparentes, parallèles, d'une épaisseur de quelques centaines à quelques milliers d'Angström, d'une largeur de 200 à 500 µm, séparées par des intervalles de 20 à 100 µm lesquels représentent ce que l'on appelle la "black matrix"; la couche conductrice transparente constituant les bandes 7 est composée d'un ou plusieurs métaux ou oxydes, tels que l'or, l'argent, l'oxyde d'étain (TO), l'oxyde mixte d'étain et d'indium (ITO), l'oxyde de zinc et le stannate de cadmium, etc., comme mentionné dans la littérature ; en outre, chacune de ces colonnes 7, est, le long de l'une de ses zones de bordure, des diverses façons qui seront décrites ci-après, en contact avec une colonne 8 d'amenée de courant supplémentaire, entre les deux extrémités de la colonne 7 associée, c'est-à-dire à l'intérieur même de l'écran. L'ensemble des colonnes 7 et des colonnes supplémentaires 8 constitue la partie conductrice d'un circuit électrique conforme à la présente invention.

Les contre-électrodes 5 se présentent sous la forme de bandes conductrices parallèles entre elles, appelées aussi "lignes" de l'écran, car elles sont disposées perpendiculairement aux colonnes 7.

On ne décrira pas ici davantage ces contre-électrodes 5, lesquelles ne sont pas nécessairement transparentes. Dans le cas où elles seraient transparentes, on peut envisager qu'elles aient la même structure que les électrodes 3 (colonnes 7 + colonnes supplémentaires 8).

L'écran 1 est complété, de façon connue, par des moyens d'amenée du courant électrique aux extrémités des colonnes 7 + 8 et des lignes 5, et par des moyens pour appliquer des signaux électriques à ces colonnes 7 + 8 et lignes 5, afin de générer, sous l'application d'un signal électrique adressé simultanément à une ligne et à une colonne, à l'intersection de celles-ci, un effet lumineux dans le matériau luminophore 6.

Les colonnes supplémentaires 8 sont formées dans des sillons 9 pratiqués dans la surface de la plaque 2, avantageusement de façon à chevaucher la "black matrix" dans toute la mesure du possible.

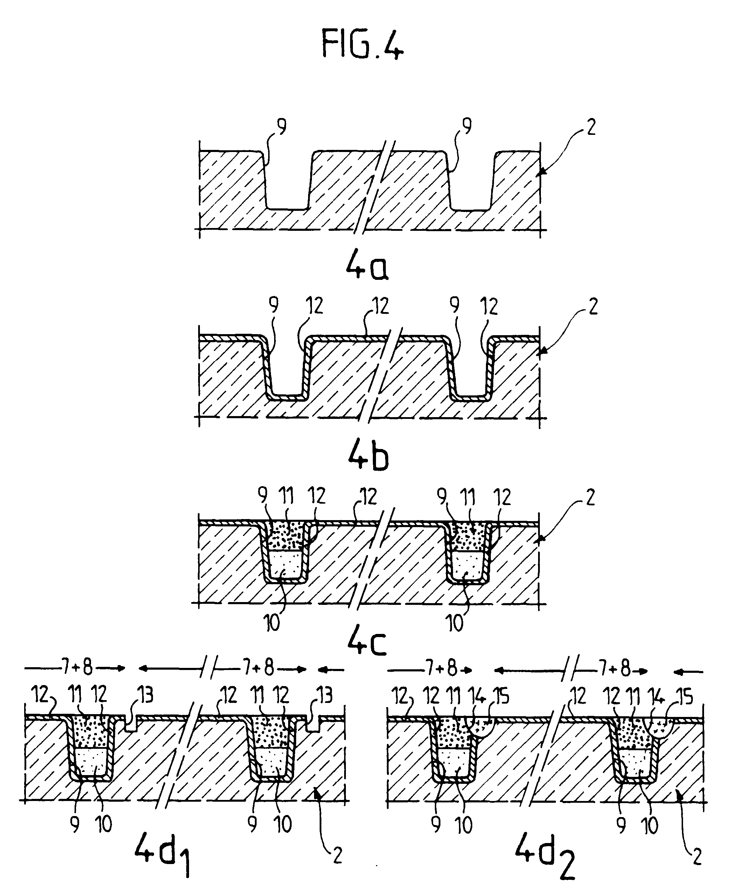

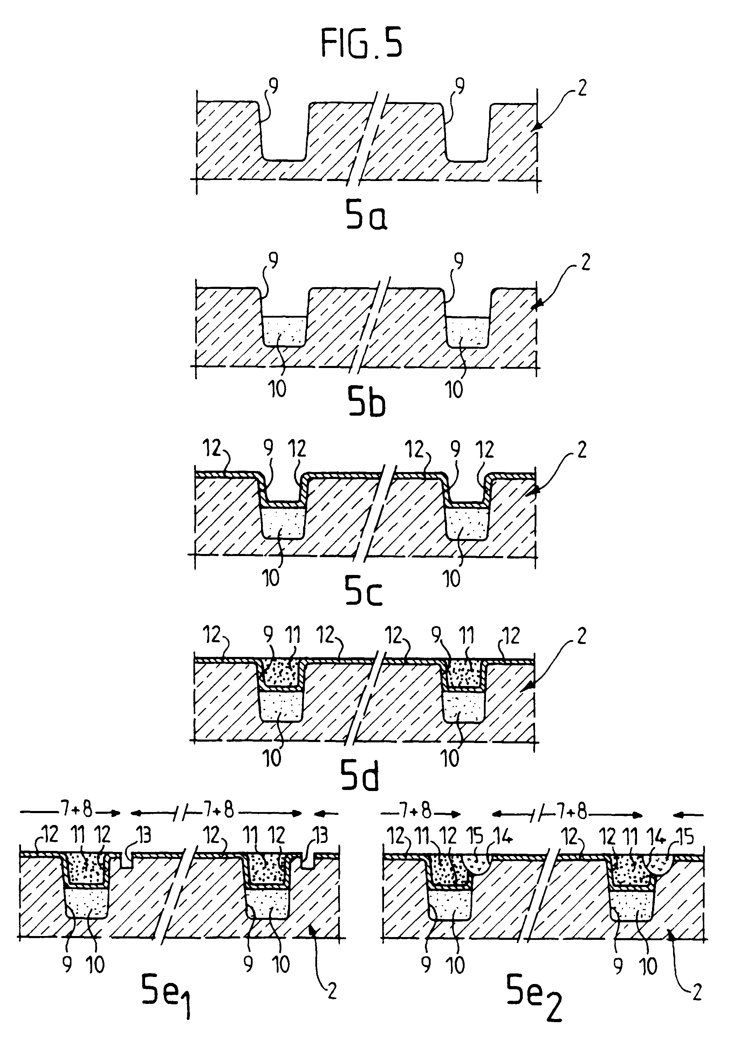

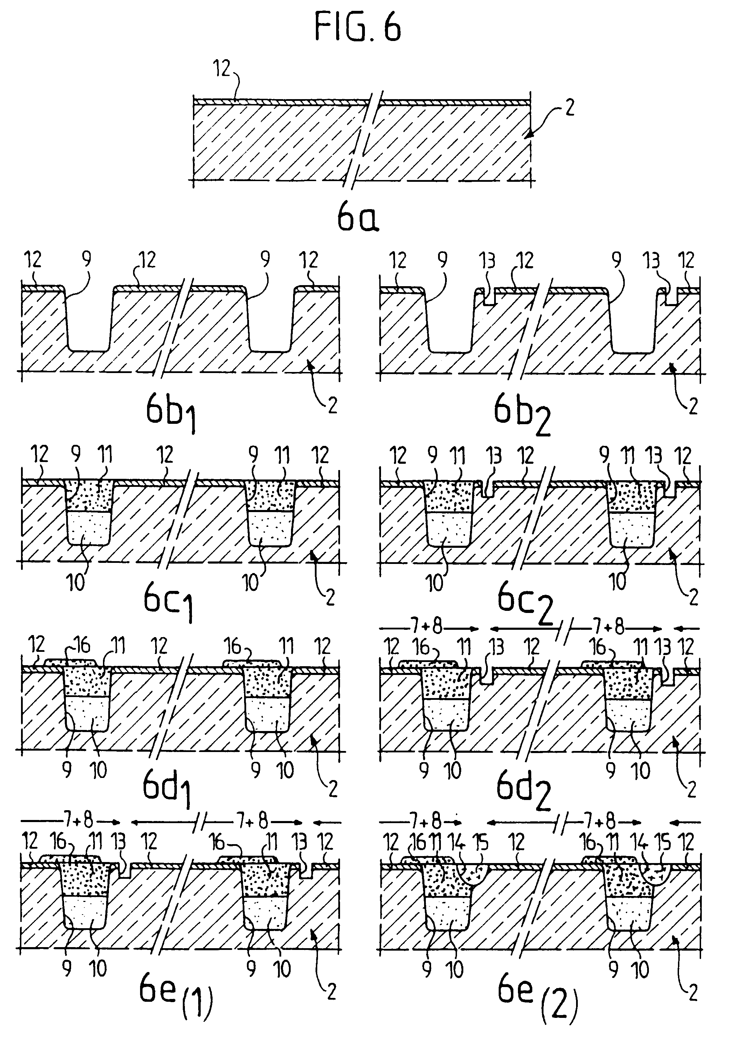

On va maintenant décrire plusieurs variantes de réalisation, parmi d'autres, de ces colonnes 7 et 8.
(1) Une première variante est représentée sur la Figure 3. On utilise une plaque de verre 2, non revêtu, dans laquelle on grave, aux intervalles choisis en fonction des dimensions prévues des colonnes 7 + 8, par l'un des procédés décrits ci-dessus, des sillons 9, parallèles, d'une profondeur de l'ordre de 30 - 100 µm, d'une largeur moyenne de l'ordre de 30 - 80 µm, ces sillons 9 comportant, par exemple, un fond relativement plat et des côtés s'évasant légèrement en direction de la surface de la plaque 2 (Figure 3a).
   Dans ces sillons 9, on installe, par l'une ou l'autre des techniques décrites ci-dessus, une couche de fond 10, conductrice, par exemple, une pâte à l'argent ou au cuivre, puis une couche supérieure protectrice et conductrice 11, par exemple un graphite ou carbone conducteur, cette dernière achevant de remplir les sillons 9 (Figure 3b).
   On procède ensuite au dépôt, sur la totalité de la surface de la plaque 2, par pulvérisation cathodique ou procédé CVD, d'une fine couche 12 d'une épaisseur de l'ordre de 0,2 - 0,9 µm, du métal ou de l'oxyde conducteur destiné à former les colonnes 7 (Figure 3c).
   Enfin, pour constituer les colonnes 7 + 8, on creuse à nouveau, par un procédé tel que décrit ci-dessus, dans la plaque 2, des rainures 13, peu profondes, parallèles aux sillons 9, au même intervalle que celui séparant ces derniers, situées chacune au voisinage d'un sillon 9, et entaillant la couche 12 et le verre sous-jacent, pour exposer la matière isolante du support 2 (Figure 3d₁).
   Pour assurer l'alternance des parties conductrices et des parties isolantes sur la plaque 2, on peut également, comme représenté sur la Figure 3d₂, creuser des gorges 14, longitudinales, à cheval sur l'un des bords des sillons 9, exposant la matière isolante du support 2 sur une partie desdites gorges 14. Si la planéité parfaite de la plaque 2 est requise, les gorges 14 peuvent être remplies par une matière 15, non conductrice, avantageusement transparente, durcissable, par exemple un polymère thermodurcissable.
   Le contact entre les colonnes 7 et 8 s'effectue, dans le cas de cette variante, sur la totalité ou la presque totalité de la surface de la couche 11.
   On peut aussi souligner le rôle de protection contre la corrosion de la couche 10 par la couche 11, vis-à-vis du matériau luminophore 6, supposé ici être corrosif, comme cela est souvent le cas dans la pratique.
(2) Une deuxième variante est décrite avec référence à la Figure 4. Dans ce cas, après avoir formé les sillons 9 comme dans le cas de la première variante (Figure 4a), on procède au dépôt, par pulvérisation cathodique ou procédé CVD, d'une couche 12 de la matière conductrice transparente devant former les colonnes 7, de façon à recouvrir entièrement la plaque 2 (Figure 4b). Puis on installe successivement les couches 10 et 11 comme dans le cas de la première variante (Figure 4c), la surface des couches 11 venant ici dans l'alignement de la surface de la couche 12. Pour achever la formation des colonnes 7 + 8, deux possibilités s'offrent alors, illustrées sur les Figures respectivement 4d₁ et 4d₂, analogues aux modes de réalisation des Figures respectivement 3d₁ et 3d₂. On ne décrira donc pas plus en détail ici la formation, soit des rainures 13, soit des gorges 14 avec leur matière de remplissage 15.
   Dans le cas de cette seconde variante, une colonne 8 (couches 10 et 11) et la colonne 7 associée (formée par la bande externe adjacente de la couche 12) sont en contact par toute la partie de la couche 12 se trouvant à l'intérieur du sillon 9. Les colonnes 7 sont donc ici très bien alimentées en courant par les colonnes supplémentaires 8.
(3) Une troisième variante est maintenant décrite avec référence à la Figure 5. Cette variante ne sera pas décrite en détail, car elle diffère de la précédente uniquement par le fait que la couche 12 est appliquée sur la totalité de la plaque 2 (Figure 5c) après formation de sillons 9 (Figure 5a) et installation des couches de fond 10 (Figure 5b). Après le dépôt de la couche 12, on complète le remplissage des sillons 9 par la couche 11 (Figure 5d), puis, de la même façon que dans les deux variantes précédentes, on forme, soit les rainures 13 (Figure 5e₁), soit les gorges 14 que l'on remplit par la matière 15 (Figure 5e₂).
   La communication électrique entre la colonne 8 et la colonne 7 associée est ici très bien renforcée, du fait qu'une partie de la couche 12 se trouve à la fois en contact avec la couche 10 et avec la couche 11 au sein du sillon 9.
(4) Une quatrième variante va maintenant être décrite avec référence à la Figure 6. On utilise une plaque 2 du commerce, prérevêtue par une couche 12 (Figure 6a).
   Conformément à un premier mode de réalisation, illustré sur les Figures 6b₁ à 6e, on forme, dans la plaque 2 prérevêtue, des sillons 9 (Figure 6b₁), dans lesquels on installe successivement les couches 10 et 11, les couches 11 venant alors dans l'alignement des parties 12 (Figure 6c₁). On dépose alors, par sérigraphie, à cheval sur la couche 12 et la surface des couches 11, des bandes 16 d'une largeur de 80 - 100 µm et d'une épaisseur de l'ordre de 4 - 8 µm, d'une matière conductrice et protectrice, identique ou du même type que la matière constituant les couches 11 (Figure 6d₁). Le contact électrique entre les colonnes 7 et 8 s'effectue ici par l'intermédiaire de ces bandes 16.

Enfin, on procède à la formation soit des rainures 13, soit des canaux 14, comme dans le cas des variantes précédentes (Figures respectivement 6e₍₁₎ et 6e₍₂₎).

Conformément à un second mode de réalisation, illustré sur les Figures 6b₉ à 6d₂, on creuse tout d'abord simultanément les sillons 9 et les rainures 13 (Figure 6b₂). Puis on procède à l'installation successive, dans les sillons 9, des couches 10 et des couches 11 (Figure 6c₂), en prenant soin de ne pas remplir les rainures 13. A cet effet, on peut, par exemple, déposer, au fond de chacune de ces rainures 13, un fil de nature plastique, dont le diamètre correspond à la largeur de la rainure. Après les opérations de remplissage des sillons 9, les fils sont arrachés, dégageant ainsi lesdites rainures.

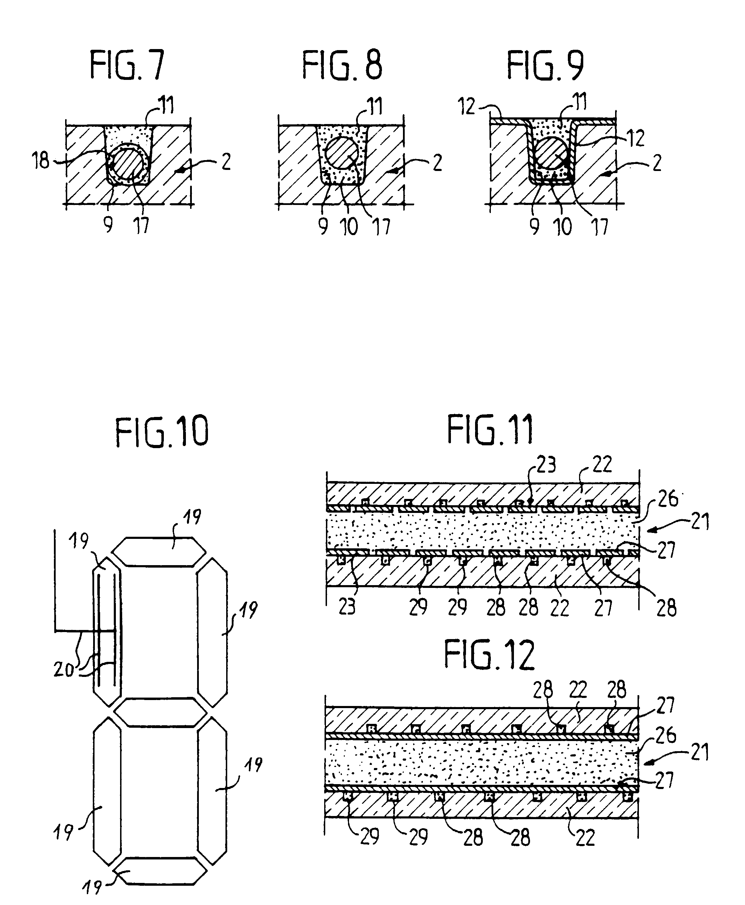

Les Figures 7 à 9 montrent d'autres modes de réalisation du remplissage des sillons 9, pouvant être utilisés dans le cadre de l'une des variantes qui viennent d'être décrites. Il apparaîtra à l'homme du métier qu'il existe encore d'autres possibilités de remplissage des sillons 9, par exemple en combinant entre eux ces modes de réalisation.

Dans le sillon 9 selon la Figure 7, on a installé un fil conducteur 17 d'un diamètre de l'ordre de 30 - 70 µm, enrobé d'une couche 18, conductrice et protectrice, par exemple en un polymère chargé d'une poudre conductrice, le diamètre du fil enrobé correspondant sensiblement à la largeur du sillon 9 à mi-hauteur, mais pouvant également être plus faible. On a complété le remplissage par la mise en place d'une pâte 11, conductrice et protectrice, du même type que la couche 11 des variantes des Figures 3 à 6. Cette variante de remplissage du sillon 9 peut remplacer par exemple celles des Figures 3 et 6.

Dans le cas de la variante de la Figure 8, on a installé, dans le fond du sillon 9, une couche conductrice 10, de même type que la couche 10 des variantes des Figures 3 à 6, puis on a mis en place un fil conducteur 17, non enrobé, et complété le remplissage par une couche conductrice et protectrice 11. Cette variante de remplissage du sillon 9 peut remplacer par exemple celles des Figures 3, 6 et 7.

Dans le sillon 9 de la Figure 9 revêtu par une couche 12, comme dans le cas des Figures 4 et 6, on a effectué un remplissage identique à celui de la Figure 8. On pourrait aussi envisager, par exemple, un remplissage du type de celui de la Figure 7.

Sur la Figure 10, on a représenté de façon schématique les sept segments chromophores 19 (ou gros pixels) d'un panneau d'affichage connu, à adressage direct, destiné à l'affichage d'un caractère alphanumérique. Ces segments 19 sont constitués chacun par une couche de matériau électrolytique située entre une couche d'électrode de travail, par exemple en oxyde d'étain, et une couche de contre-électrode. On a également représenté schématiquement, pour l'un de ces pixels, un circuit 20 d'amenée et renfort de courant, réalisé selon l'invention, par des sillons pratiqués dans le support associé et remplis de matière conductrice, telle qu'une colle ou encre à base de cuivre ou d'argent éventuellement protégée. Un circuit du même type est associé à chaque pixel. Cette figure illustre une disposition de sillons autre que celle de sillons rectilignes parallèles.

Si l'on se réfère maintenant à la Figure 11, on voit que l'on a représenté un vitrage à propriétés variables, constitué, de façon connue, par deux supports en verre 22, espacés l'un de l'autre, portant chacun un circuit d'électrodes 23, les électrodes 23 étant disposées en regard, avec interposition d'une couche luminophore 26, par exemple comprenant de façon connue un sel de métal de transition, tel que WO₃ (couche électrochrome) ou encore des cristaux liquides dispersés dans un polymère (PDLC).

Les électrodes 23 ont une structure qui est sensiblement analogue à celle des "colonnes" de l'écran représenté sur la Figure 2, autrement dit, elles sont constituées par des bandes conductrices 27 par exemple de TO ou d'ITO, parallèles, chacune ayant sa conductibilité renforcée par une partie conductrice 28 remplissant un sillon 29, et en communication par la totalité de leur surface supérieure avec la bande 27 associée.

Les sillons 29, sensiblement de même dimension que les sillons 9 précédemment décrits, sont parallèles entre eux et équidistants de 50 à 1000 µm, pratiqués dans les deux plaques 22, les sillons 29 d'une plaque étant décalés d'un demi-intervalle par rapport aux sillons 9 de l'autre plaque. Cependant, toute autre disposition relative des sillons 29 est également envisageable.

Différents modes de remplissage des sillons 29 sont possibles, tels que ceux des Figures 3 à 6, 3d₁ ou 3d₂, ou 4d₁ ou 4d₂, ou 5e₁ ou 5e₂, ou 6e₍₁₎, 6e₍₂₎ ou 6c₂ ou 6d₂, 7, 8 et 9.

Les bandes 27 ont une largeur de l'ordre de 200 - 1000 µm, et elles sont écartées d'une distance égale, de l'ordre de 50 - 200 µm. Par ailleurs, bien que les bandes 27, formées sur une plaque 22, soient représentées sur la Figure 11 comme étant disposées en quinconce par rapport à celles de l'autre plaque 22, d'autres dispositions sont possibles. Le vitrage de la Figure 11 permet une commande indépendante du potentiel des bandes 27 + 28.

Sur la Figure 12, on a représenté une autre variante de réalisation du vitrage à propriétés variables, qui diffère de la précédente par le fait que les bandes 27 sont remplacées par des couches continues, n'autorisant qu'une commande de tension équipotentielle sur chaque couche 27. Les parties conductrices 28 permettent ici d'améliorer l'uniformité de la teinte sur l'ensemble du vitrage 21. Les Figures 3c, 4c, 5d, 6c₁, 6d₁ illustrent d'autres structures possibles pour la combinaison des plaques 22 et des électrodes de la Figure 12, en combinaison également avec les variantes des Figures 7 à 9.

Les Exemples suivants illustrent encore la présente invention.

### EXEMPLE 1 (cf. Figure 3b) :

Dans une plaque de verre 2, de 2 mm d'épaisseur, préalablement traitée en surface par pulvérisation d'un produit hydrophile du commerce, des sillons 9, de 35 µm de largeur moyenne et de 30 µm de profondeur, ont été tracés à l'aide d'une scie "DISCO DAD 2 H6/T" utilisant des lames diamantées. Cette scie, habituellement utilisée pour la découpe de pastilles de silicium, a une précision dans chacune des trois dimensions qui est de l'ordre du micron. On a ainsi créé un réseau très régulier de 150 sillons 9 parallèles, distants de 350 µm.

Avec une raclette de sérigraphie, on a déposé, dans ces sillons 9, plusieurs couches d'une pâte à l'argent (ACHESON, DEMETRON, MINICO), sur une épaisseur totale de 25 µm. Après une cuisson à environ 120-150°C, on a obtenu, dans les sillons 9, des parties conductrices 10 ayant une résistance de 4 ohms environ pour 3 cm de largeur de la plaque. Le remplissage des sillons 9 a été ensuite achevé par le dépôt d'une couche 11 d'encre graphitée protectrice (MINICO de la série 5000) (25 Ω/cm pour 10 µm d'épaisseur), que l'on a fait polymériser à la chaleur.

Des tests de corrosion ont montré que le réseau conducteur ainsi réalisé était parfaitement protégé contre la corrosion par un milieu de pH 2.

### EXEMPLE 2 (cf. Figure 8) :

Dans une plaque de verre 2, de 2 mm d'épaisseur, on a créé, par le même procédé qu'à l'Exemple 1, à des intervalles de 500 µm, des sillons 9 d'une largeur et d'une profondeur d'environ 50 µm chacune.

Une couche 10 d'encre carbonée, d'une épaisseur de 10 µm, y a été déposée par la technique décrite à l'Exemple 1. Avant séchage de l'encre 10, des fils de cuivre 17, d'un diamètre de 30 µm, ont été installés dans les sillons 9, à l'aide d'un équipement de "Wedge Bonding", type KULICKE et SOFA ou PRECIMECA, lequel a permis d'effectuer une première soudure sur un substrat métallique extérieur à la plaque de verre 2, de tirer les fils 17 dans les sillons 9, puis d'effectuer une deuxième soudure tout en tirant et en coupant les fils 17. On a pu ainsi disposer une centaine de fils 17 dans les sillons 9. On a ensuite complété le remplissage de ces derniers avec des couches 11 d'encre graphitée protectrice, du même type que celle de la couche 11 de l'Exemple 1.

On est ainsi parvenu à des résistances de l'ordre de 0,06 Ω/cm de longueur de sillon.

### EXEMPLE 3 (cf. Figure 11) :

Dans une plaque de verre 22, de 2 mm d'épaisseur, préalablement traitée en surface par un produit hydrophobe du commerce, des sillons parallèles 29 de 30 µm de largeur et de 30 µm de profondeur, ont été gravés à des intervalles de 300 µm, à l'aide d'un laser LUMONIX EXCIMER UV, en utilisant une longueur d'onde de 193 nanomètres et des impulsions de 10 à 30 ns à une fréquence de 200 Hz. Une table de positionnement à commande numérique a permis cette réalisation à 1 µm près.

Les sillons 29 ainsi obtenus ont été ensuite remplis à mi-hauteur avec une pâte métallique obtenue par mélange de poudre d'étain et de poudre de plomb dans un rapport pondéral 60/40, avec une quantité juste suffisante d'eau. La formation des parties conductrices par fusion des poudres a été conduite par chauffage de la plaque 22, dans un four à balayage de gaz réducteur (par exemple, hydrogène à 4% dans de l'azote), à une température supérieure au point de fusion des poudres métalliques composant la pâte.

On complète le remplissage des sillons avec une encre carbonée conductrice par la méthode décrite dans l'Exemple 1. Puis il est déposé par pulvérisation cathodique une couche ITO recouvrant le verre 22 et les sillons remplis 29. Celle-ci est ensuite gravée, par des moyens connus, en bandes 27, parallèles aux sillons, de 250 µm de large, écartées de 50 µm, la bande 27 étant à cheval sur le sillon.

Deux plaques de verre identiques sont disposées en regard, de sorte que les sillons 29 d'une plaque soient décalés d'un demi-intervalle par rapport aux sillons 29 de l'autre plaque. Ces deux plaques de verre encapsulent un polymère transparent d'association adhésivé dans lequel sont dispersés des cristaux liquides. Cette cellule ainsi assemblée constitue un vitrage à propriétés variables et commandables sur tout ou parties de la surface selon le branchement électrique effectué.

### EXEMPLE 4 (cf. Figure 4) :

Dans une plaque de verre 2, de 2 mm d'épaisseur, des sillons 9 séparés par des intervalles de 350 µm, ont été créés par le procédé décrit dans les Exemples 1 et 2, à l'aide d'une lame diamantée de 80 µm, sur une profondeur de 30 µm (Fig. 4a).

La plaque 2 a été alors soumise à un traitement de pulvérisation cathodique, permettant de la recouvrir entièrement, y compris sur la paroi interne des sillons 9, d'une fine couche 12 d'oxyde d'étain transparent de 0,4 µm d'épaisseur (Fig. 4b).

On a ensuite installé successivement dans les sillons 9, selon le procédé décrit à l'Exemple 1, une couche à l'argent 10, puis une couche d'encre graphitée protectrice 11, que l'on a soumise à polymérisation (Figure 4c).

A l'aide d'une machine DISCO, des gorges 14, de 20 µm de largeur et de 2 à 6 µm de profondeur, ont été creusées chacune à cheval sur l'un des bords des sillons 9 ainsi remplis, exposant le verre sur sensiblement une moitié des gorges 14. Puis, pour rétablir la planéité parfaite de la plaque 2, on a rempli les gorges 14 avec une composition polymérisable 15 d'encre isolante que l'on a fait durcir à 150°C (Figure 4d₂).

On a ainsi obtenu un support 2 comportant des colonnes conductrices 7, séparées par les surfaces isolantes du polymère 15 et très bien alimentées en courant par les colonnes supplémentaires 8 formées par les parties conductrices 10 et 11 placées dans les sillons 9 respectifs. Les colonnes 8 sont en très bonne communication électrique avec les colonnes 7, grâce au contact avec la couche 12 d'oxyde d'étain se trouvant dans les sillons 9 eux-mêmes.

Il est bien entendu que les modes de réalisation ci-dessus décrits ne sont aucunement limitatifs et pourront donner lieu à toutes modifications désirables, sans sortir pour cela du cadre de l'invention.

## Revendications

1. Circuit électrique à très haute conductibilité et de grande finesse, destiné notamment à entrer dans la constitution de dispositifs de modulation de la lumière ou d'affichage de différentes sortes, tels qu'électroluminescents, électrochromiques, ou à cristaux liquides, de vitrages et valves à propriétés optiques variables, de dispositifs de chauffage électrique à courant de puissance et de circuits électroniques de puissance, ledit circuit comportant :
- un support (2 ; 22) en une matière isolante ;
- recouvert, sur au moins une partie de sa surface, par une fine couche conductrice (7 ; 27), dont la forme géométrique correspond au schéma choisi pour le circuit électrique ;
- ladite couche conductrice étant parcourue par un ou plusieurs sillons très fins (9 ; 29) gravés dans le support, d'une profondeur supérieure à 6 µm ;
- ledit (ou lesdits) sillon(s) (9 ; 29) étant entièrement rempli(s) par au moins deux composants superposés :
. le(s) premier(s), situé(s) au fond du sillon, constitué(s) par un matériau fortement conducteur, à savoir soit un fil conducteur (17) ou un profilé conducteur, soit une substance conductrice obtenue par traitement d'un matériau précurseur (10), liquide, pulvérulent ou pâteux, mis en place au préalable dans le sillon, ledit traitement ayant donné audit matériau précurseur (10) sa consistance dure et ses propriétés définitives ;
. le dernier, assurant le rebouchage du sillon, obtenu par traitement d'un matériau précurseur (11) liquide, pulvérulent ou pâteux, conducteur ou non, ledit traitement ayant donné audit matériau précurseur (11) sa consistance dure et ses propriétés définitives ;
- la couche conductrice (7 ; 27) étant déposée de telle sorte qu'elle soit en contact avec le(s) composant(s) conducteur(s) placé(s) dans le sillon (9 ; 29) soit avant remplissage, soit à un stade intermédiaire, soit après rebouchage du sillon.

2. Circuit électrique selon la revendication 1, caractérisé par le fait que le rapport de gravure latérale à verticale du (ou des) sillons (9 ; 29) est inférieur à 1:1,

3. Circuit électrique selon l'une des revendications 1 et 2, caractérisé par le fait que la profondeur des sillons (9 ; 29) est supérieure à 15 µm.

4. Circuit électrique selon l'une des revendications 1 à 3, caractérisé par le fait que les fils conducteurs (17) comportent un enrobage protecteur (18), conducteur, ledit enrobage (18) pouvant également avoir subi, une fois le fil (17) mis en place, un traitement le consolidant et lui donnant ses propriétés définitives.

5. Circuit électrique selon l'une des revendications 1 à 4, caractérisé par le fait qu'un matériau précurseur (10-11) introduit dans le ou les sillons (9 ; 29), soit au fond, soit en rebouchage, a été placé sous sa forme définitive par fusion reconstituant l'analogue d'un fil métallique, par un traitement thermique, par micro-ondes ou par infrarouges, dans le cas d'une poudre métallique ou d'une poudre métallique placée sous la forme de pâte à l'eau ou d'encre conductrice ; par séchage dans le cas d'une pâte ou encre de type pour emploi dans la sérigraphie ou du type chargée au carbone ou d'une colle conductrice, en vue de l'évaporation de l'eau ou au solvant qui y est contenu ; par polymérisation ou durcissement dans le cas de compositions polymérisables ou de compositions de polymères thermodurcissables.

6. Circuit électrique selon l'une des revendications 1 à 5, caractérisé par le fait que la partie conductrice (3 ; 23) est constituée par au moins une substance conductrice (10-11-17-18 ; 28) installée dans le ou les sillons (9 ; 29) sans former de relief à la surface du support (2 ; 22), et par une couche conductrice (7 ; 27) continue ou discontinue, déposée sur le support, le ou les conducteurs remplissant le ou les sillons étant disposés pour constituer des moyens (8 ; 28) d'amenée de courant supplémentaire à la couche conductrice (7 ; 27), des moyens étant prévus pour assurer la communication électrique entre ladite couche (7 ; 27) et les moyens (8 ; 28) d'amenée de courant supplémentaire.

7. Circuit électrique selon la revendication 6, caractérisé par le fait que les moyens assurant la communication électrique entre la couche conductrice (7 ; 27) et les moyens (8 ; 28) d'amenée de courant supplémentaire sont constitués par un prolongement de ladite couche conductrice (7 ; 27) sur la paroi intérieure du sillon (9 ; 29), au sein de la partie conductrice se trouvant dans le sillon (9 ; 29), ou sur la surface supérieure de ladite partie conductrice se trouvant dans le sillon (9 ; 29).

8. Circuit électrique selon la revendication 6, caractérisé par le fait que les moyens assurant la communication électrique entre la couche conductrice (7) et les moyens (8) d'amenée de courant supplémentaire sont constitués par des bandes conductrices (16) disposées de façon à chevaucher la couche conductrice (7) et la surface supérieure de la partie conductrice se trouvant dans le sillon (9).

9. Circuit électrique selon l'une des revendications 6 à 8, caractérisé par le fait que la couche conductrice (7 ; 27) est discontinue, la discontinuité étant créée par un dépôt de la couche (27) en parties discontinues, ou par des rainures (13) ou des gorges (14) pratiquées dans le support (2), à travers ladite couche ou à cheval sur l'une des bordures supérieures des sillons (9), de façon à exposer la matière isolante constituant le support (2), lesdites rainures (13) ou gorges (14) pouvant être remplies par une matière non conductrice (15) reconstituant la continuité de surface dudit support (2).

10. Circuit électrique selon l'une des revendications 1 à 9, caractérisé par le fait que le support (2 ; 22) est un support plat, et les sillons (9 ; 29) sont des sillons disposés de façon rectiligne et parallèlement entre eux, et coopérant avec une couche conductrice (7 ; 27) revêtant le support, continue ou sous forme de bandes parallèles aux sillons, au moins un sillon pouvant être associé à une bande.

11. Procédé de fabrication d'un circuit électrique tel que défini à l'une des revendications 1 à 10, caractérisé par le fait que :
- on creuse, à la surface d'un support (2 ; 22) en matière isolante, le cas échéant revêtu par une couche conductrice mince (12), le ou les sillons (9 ; 29) en fonction du schéma de circuit choisi, une couche mince de matière conductrice pouvant ensuite être déposée sur des parties ou sur la totalité de la surface du support, y compris des sillons, dans le cas où ledit support n'était pas préalablement revêtu ;
- on assure le remplissage des sillons par l'introduction d'au moins une couche de matériau précurseur de couche conductrice (10, 11 ; 28), pulvérulent ou de consistance liquide à pâteuse, approprié pour pouvoir être installé dans lesdits sillons et/ou par le positionnement direct d'un fil conducteur (17), éventuellement doté d'un enrobage conducteur, en terminant le cas échéant le remplissage par une couche de matériau pulvérulent ou de consistance liquide à pâteuse, précurseur de couche protectrice, conductrice ou non, neutre vis-à-vis de son environnement ;
- après mise en place d'au moins un matériau précurseur, on conduit un traitement approprié de ce dernier pour lui donner ses forme, consistance et propriétés définitives, une couche mince de matière conductrice pouvant, dans le cas d'un support préalablement revêtu, être déposée au cours du remplissage des sillons, sur des parties ou sur la totalité du support, y compris des sillons, entre deux couches de remplissage de ceux-ci, ou bien être déposée après le remplissage des sillons sur des parties ou sur la totalité du support ; et
- dans le cas où la couche mince externe doit être discontinue, on forme des rainures (13) ou gorges (14), de façon à exposer le support en matière isolante, selon le schéma de circuit choisi, les rainures ou gorges pouvant ensuite être remplies par une matière non conductrice (15).

12. Procédé selon la revendication 11, caractérisé par le fait que l'on creuse les sillons par gravure au laser, pressage, injection, refoulage, sablage, rodage, meulage, jet d'eau haute pression, usinage par ultrasons ou érosion.

13. Procédé selon la revendication 11, caractérisé par le fait qu'on installe les couches successives de matériau précurseur par application d'une substance pulvérulente ou de consistance liquide à pâteuse du matériau précurseur sur la surface du support portant les sillons et retrait de la substance n'ayant pas pénétré dans ceux-ci ou application d'une pâte ou encre à la raclette ou à l'aide d'une roulette d'encrage, un traitement destiné à rendre non mouillable par l'encre la surface du support ayant pu avoir été réalisé, préalablement à la formation des sillons, pour que l'encre appliquée se réfugie sensiblement exclusivement dans les sillons.

14. Procédé selon la revendication 11, caractérisé par le fait qu'on donne au matériau précurseur installé dans un sillon sa forme et/ou structure définitive par fusion reconstituant l'analogue d'un fil métallique, par un traitement thermique, par micro-ondes ou par infrarouges, dans le cas d'une poudre métallique ou d'une poudre métallique placée sous la forme de pâte à l'eau ou d'encre conductrice ; par séchage dans le cas d'une pâte ou encre de type pour emploi dans la sérigraphie ou du type chargée au carbone ou d'une colle conductrice, en vue de l'évaporation de l'eau ou du solvant qui y est contenu ; par polymérisation ou durcissement dans le cas de compositions polymérisables ou de compositions de polymères thermodurcissables.

15. Dispositif comportant au moins un circuit électrique tel que défini à l'une des revendications 1 à 10, ou fabriqué par le procédé tel que défini à l'une des revendications 11 à 14.

16. Dispositif selon la revendication 15 pour la modulation de la lumière ou l'affichage, tel qu'électroluminescent, électrochromique, à cristaux liquides, ou de type vitrage ou valve à propriétés optiques variables, comportant deux supports portant, l'un, un circuit d'électrodes, et l'autre, un circuit de contre-électrodes, les deux circuits étant disposés en regard avec interposition d'une couche luminophore, caractérisé par le fait qu'au moins l'un des deux circuits d'électrodes est tel que défini à l'une des revendications 1 à 10, ou fabriqué par le procédé tel que défini à l'une des revendications 11 à 14.

17. Dispositif selon la revendication 16, consistant en un écran ou afficheur composé de cellules commandées selon un mode matriciel, les circuits d'électrodes et de contre-électrodes étant constitués respectivement de colonnes parallèles conductrices et de lignes parallèles conductrices, disposées perpendiculairement par rapport aux colonnes, caractérisé par le fait qu'au moins le circuit des électrodes est un circuit tel que défini à la revendication 10.

18. Dispositif selon la revendication 16, consistant en un vitrage ou une valve à propriétés variables, caractérisé par le fait que les deux circuits sont tels que définis à l'une des revendications 1 à 10, des moyens pouvant être prévus pour assurer une commande indépendante du potentiel des parties conductrices de chaque sillon et, le cas échéant, de la couche conductrice externe associée à celui-ci, dans le cas où cette couche est discontinue.

## Patentansprüche

1. Elektrische Schaltung mit sehr hoher Leitfähigkeit und großer Feinheit, bestimmt insbesondere zur Verwendung für die Bildung von Modulationseinrichtungen für Beleuchtung oder Anzeigeeinrichtungen unterschiedlicher Art, insbesondere elektrolumineszierende, elektrochrome oder solche mit Flüssigkristallen, von Gläsern oder Blenden unterschiedlicher optischer Eigenschaften, von elektrischen Heizeinrichtungen mit Leistungsstrom oder elektronischen Leistungskreisen, welche Schaltung umfaßt:
- einen Träger (2; 22) aus isolierendem Material;
- der wenigstens auf einem Teil seiner Oberfläche mit einer feinen leitenden Schicht (7; 27) bedeckt ist, deren geometrische Form dem Schema entspricht, das für die elektrische Schaltung verwendet wird,
- welche leitende Schicht durchzogen ist von einer Anzahl von sehr feinen Rinnen (9; 29), die in den Träger eingearbeitet sind, von einer Tiefe von mehr als 6 µm;
- welche Rinnen (9; 29) vollständig gefüllt sind mit wenigstens zwei übereinander angeordneten Bestandteilen:
. welcher erste Bestandteil am Boden der Rinne gebildet ist durch ein stark leitendes Material, etwa ein leitendes Band (17) oder ein leitendes Profil, sei es eine leitende Substanz, die erhalten worden ist durch Behandlung eines flüssigen, pulverförmigen oder pastösen Vorläufermaterials (10), das zuvor in die Rinne eingebracht worden ist, welche Behandlung dem Vorläufermaterial (10) eine harte Konsistenz und seine definitiven Eigenschaften gegeben hat;
. welcher zweite Bestandteil den Wiederverschluß der Rinne gewährleistet und erhalten wird durch Behandlung eines flüssigen, pulverförmigen oder pastösen Vorläufermaterials (11) in der Form eines leitenden oder nichtleitenden Materials, welche Behandlung dem Vorläufermatertal (11) eine harte Konsistenz und seine definitiven Eigenschaften verliehen hat;
- welche leitende Schicht (7; 27) derart aufgebracht ist, daß sie in Berührung steht mit dem oder den leitenden Bestandteilen in der Rinne (9; 29), sei es vor dem Füllen, sei es in einem Zwischenstadium, sei es nach dem Füllen der Rinne.

2. Elektrische Schaltung nach Anspruch 1, dadurch **gekennzeichnet**, daß das Verhältnis zwischen der Breite und Höhe der Rinne(n) (9; 29) kleiner als 1:1 ist.

3. Elektrische Schaltung nach Anspruch 1 oder 2, dadurch **gekennzeichnet**, daß die Tiefe der Rinnen (9; 29) größer als 15 µm ist.

4. Elektrische Schaltung nach einem der Ansprüche 1 bis 3, dadurch **gekennzeichnet**, daß die Leitungsdrähte (17) eine Schutzhülle (18) aufweisen, die leitend ist, welche Schutzhülle (18) auch aufgebracht werden kann, wenn die Drähte (17) in ihrer Position liegen, durch welche Behandlung die Drähte festgelegt werden und ihre endgültigen Eigenschaften erhalten.

5. Elektrische Schaltung nach einem der Ansprüche 1 bis 4, dadurch **gekennzeichnet**, daß ein Vorläufermaterial (10-11), das in die Rinne(n) (9; 29) am Boden oder als Deckschicht eingebracht wird, in der endgültigen Form durch Schmelzen angebracht wird und eine Art von metallischem Draht bildet, indem eine thermische Behandlung mit Hilfe von Mikrowellen oder Infrarotlicht verwendet wird, wenn ein metallisches Pulver oder ein metallisches Pulver in der Form einer Paste mit Wasser oder leitender Tinte verwendet wird; oder durch Trocknung im Falle einer Paste oder einer Druckfarbe, wie sie für den Siebdruck verwendet wird, oder einer solchen, die mit Kohlenstoff versehen ist, oder eines leitenden Klebstoffes im Hinblick auf die Verdampfung des Wassers oder des Lösungsmittels, das darin enthalten ist; oder durch Polymerisation oder Aushärten im Falle einer polymerisierbaren Substanz oder Gemischen aus thermisch aushärtbaren Polymeren.

6. Elektrische Schaltung nach einem der Ansprüche 1 bis 5, dadurch **gekennzeichnet**, daß der leitende Bereich (3; 23) gebildet ist durch wenigstens eine leitende Substanz (10-11-17-18; 28), die in der Rinne(n) (9; 29) ohne Bildung einer Erhöhung auf der Oberfläche des Trägers (2; 22) angebracht wird, und durch eine zusammenhängende oder unterbrochene leitende Schicht (7; 27), die auf dem Träger angebracht ist, wobei der oder die Leiter, die die Rinne(n) füllen, angebracht werden zur Bildung von Zuleitungen (8; 28) für zusätzlichen Strom zur leitenden Schicht (7; 27), wobei Mittel vorgesehen sind zur Gewährleistung der elektrischen Verbindung zwischen der Schicht (7; 27) und den Zuleitungen (8; 28) des zusätzlichen Stroms.

7. Elektrische Schaltung nach Anspruch 6, dadurch **gekennzeichnet**, daß die Zuleitungen die elektrische Verbindung zwischen der leitenden Schicht (7; 27) und den Zuleitungen (8; 28) für zusätzlichen Strom gebildet werden durch eine Verlängerung der leitenden Schicht (7; 27) auf der inneren Wand der Rinnen (9; 29), innerhalb des leitenden Bereichs in den Rinnen (9; 29) oder auf der Oberfläche des leitenden Bereichs in den Rinnen (9; 29).

8. Elektrische Schaltung nach Anspruch 6, dadurch **gekennzeichnet**, daß die Zuleitungen die elektrische Verbindung zwischen der leitenden Schicht (7) und den Zuleitungen (8) für zusätzlichen Strom gebildet werden durch leitende Bänder (16), die die leitende Schicht (7) und die obere Oberfläche des leitenden Bereichs in den Rinnen (9) überdecken.

9. Elektrische Schaltung nach einem der Ansprüche 6 bis 8, dadurch **gekennzeichnet**, daß die leitende Schicht (7; 27) diskontinuierlich ist, welche Diskontinuität erzeugt wird durch Ablagerung der Schicht (28) in unterbrochenen Abschnitten, oder durch Furchen (13) oder durch Rillen (14) in dem Träger (2) über die leitende Schicht hinweg oder auf einem der oberen Ränder der Rinnen (9), indem das isolierende Material, das den Träger (2) bildet, freigelegt wird, welche Furchen (13) oder Rillen (14) mit einem nichtleitenden Material (15) gefüllt werden können zur Wiederherstellung der Geschlossenheit der Oberfläche des Trägers (2).

10. Elektrische Schaltung nach einem der Ansprüche 1 bis 9, dadurch **gekennzeichnet**, daß der Träger (2; 22) ein flacher Träger ist und daß die Rinnen (8; 29) geradlinig und zueinander parallel ausgeführt werden, im Zusammenwirken mit einer leitenden Schicht (7; 27), die den Träger abdeckt und kontinuierlich oder in Form von parallelen Streifen in den Rinnen ausgebildet ist, wobei wenigstens eine Rinne einem Band zugeordnet sein kann.

11. Verfahren zur Herstellung einer elektrischen Schaltung nach einem der Ansprüche 1 bis 10, **gekennzeichnet** durch folgende Schritte:
- Auf der Oberfläche eines Trägers (2; 22) aus isolierendem Material, das mit einer dünnen leitenden Schicht (12) überzogen ist, werden eine oder mehrere Rinnen (9; 29) entsprechend der gewählten Schaltung hergestellt, wobei anschließend eine dünne Schicht aus leitendem Material auf Teilen oder der Gesamtheit der Oberfläche des Trägers einschließlich der Rinnen angebracht werden kann, wenn der Träger zuvor nicht überzogen worden ist;
- die Rinnen werden gefüllt durch Einfügen wenigstens einer Schicht eines Vorläufermaterials der leitenden Schicht (10,11; 28), das pulverförmig oder flüssig bis pastös sein kann und geeignet zur Anbringung in den Rinnen und/oder zur direkten Ausbildung eines leitenden Drahtes (17), eventuell versehen mit einer leitenden Hülle, indem gegebenenfalls das Füllen mit einer Schicht aus pulverförmigem Material oder aus flüssigem bis pastösem Material als Vorläufer einer Schutzschicht, die leitend ist oder nicht sowie gegenüber der Umgebung neutral, beendet wird;
- nach dem Anbringen wenigstens eines Vorläufermaterials erfolgt eine geeignete Behandlung des Vorläufermaterials; die diesem seine Form, Konsistenz und endgültigen Eigenschaften verleiht, wobei eine dünne Schicht aus leitendem Material im Falle, daß der Träger zuvor überzogen worden ist, während des Füllens der Rinnen aufgebracht werden kann auf Teilbereichen oder dem gesamten Träger einschließlich der Rinnen zwischen zwei Füllschichten der Rinnen, oder nach dem Füllen der Rinnen auf Teilbereichen oder der Gesamtheit des Trägers angebracht wird;
- im Falle, daß die dünne äußere Schicht diskontinuierlich ist, werden Furchen (13) oder Rillen (14) gebildet, durch die der Träger als isolierendes Material freigelegt wird, nach dem Schema der gewählten Schaltung, welche Furchen oder Rillen anschließend gefüllt werden können mit einem nichtleitenden Material (15).

12. Verfahren nach Anspruch 11, dadurch **gekennzeichnet**, daß die Rinne durch Laser-Gravur, Pressen, Spritzen, Riffeln, Sandstrahlen, Schleifen, Fräsen, Hochdruck-Wasserstrahlbearbeitung, Herstellen mit Ultraschall oder durch Erosion hergestellt wird.

13. Verfahren nach Anspruch 11, dadurch **gekennzeichnet**, daß die aufeinander folgenden Schichten des Vorläufermaterials hergestellt werden durch Aufbringen einer pulverförmigen oder flüssigen bis pastösen Konsistenz des Vorläufermaterials auf die Oberfläche des Trägers, der die Rinnen aufweist, und die Substanz, die nicht in die Rinnen eingedrungen ist, entfernt oder durch Aufbringen einer Paste oder Druckfarbe mit einer Rakel oder eine Druckwalze, wobei eine Behandlung vorgesehen werden kann, durch die die Oberfläche des Trägers nicht benutzbar für die Druckfarbe gemacht wird, bevor die Rinnen gebildet werden, damit die aufgebrachte Druckfarbe sich ausschließlich in den Rinnen ansammelt.

14. Verfahren nach Anspruch 11, dadurch **gekennzeichnet**, daß das Vorläufermaterial, das in den Rinnen angebracht wird, die endgültige Form und/oder Struktur durch Schmelzen erhält, wobei eine Art von metallischem Draht gebildet wird, indem eine thermische Behandlung mit Mikrowellen oder Infrarotlicht im Falle eines metallischen Pulvers oder eines metallischen Pulvers in der Form einer Paste mit Wasser oder leitender Druckfarbe durchgeführt wird; durch Trocknung im Falle einer Paste oder Druckfarbe, wie sie für den Siebdruck verwendet wird, oder einer solchen, die mit Kohlenstoff versetzt ist, oder eines leitenden Klebstoffs im Hinblick auf die Verdampfung des Wassers oder des Lösungsmittels, das enthalten ist; und durch Polymerisation oder Aushärten im Falle eines polymerisierbaren Gemisches oder eines Gemisches von thermisch aushärtbaren Polymeren.

15. Vorrichtung mit wenigstens einer elektrischen Schaltung gemäß einem der Ansprüche 1 bis 10, oder hergestellt mit dem Verfahren gemäß einem der Ansprüche 11 bis 14.

16. Vorrichtung nach Anspruch 15 zur Modulation von Beleuchtung oder Anzeigeeinrichtungen, etwa elektrolumineszierenden, elektrochrome oder einer solchen mit Flüssigkristallen, oder mit Gläsern oder Blenden mit variablen optischen Eigenschaften, mit zwei Trägern, von denen einer eine Elektrodenschaltung und der andere eine Gegenelektroden-Schaltung trägt, wobei die beiden Schaltungen in bezug auf eine eingefügte luminofore Schicht angeordnet sind, dadurch gekennzeichnet, daß wenigstens eine der Elekrodenschaltungen gemäß einem der Ansprüche 1 bis 10 ausgebildet oder gemäß dem Verfahren nach einem der Ansprüche 11 bis 14 hergestellt ist.

17. Vorrichtung nach Anspruch 16, bestehend aus einem Bildschirm oder einem Anzeigegerät, zusammengesetzt aus Zellen, die nach Matritzenart gesteuert werden, welche Elektrodenschaltungen und Gegenelektroden-Schaltungen gebildet sind aus parallelen, leitenden Kolonnen und parallel leitenden Linien, die senkrecht zu den Kolonnen angeordnet sind, dadurch gekennzeichnet, daß wenigstens eine der Elektrodenschaltungen gemäß Anspruch 10 ausgebildet ist.

18. Vorrichtung nach Anspruch 16, bestehend aus einem Glas oder einer Blende mit variablen Eigenschaften, dadurch gekennzeichnet, daß die beiden Schaltungen gemäß einem der Ansprüche 1 bis 10 ausgebildet sind, daß Mittel vorgesehen werden können, die eine unabhängige Steuerung des Potentials der leitenden Teile jeder Rinne gestatten, und ggf. eine leitende äußere Schicht in Verbindung mit diesen, wenn jede Schicht diskontinuierlich ist.

## Claims

1. Electrical circuit with very high conductivity and high fineness, designed in particular to form part of light modulation or display devices of different kinds such as electroluminescent, electrochromic or liquid crystal devices, glazing and valves with variable optical properties, electric heating devices using a power current and electronic power supply circuits, the said circuit comprising:
- a substrate (2; 22) made of insulating material;
- covered on at least part of its surface by a fine conducting layer (7; 27) whose geometrical form corresponds to the layout chosen for the electrical circuit;
- the said conducting layer having one or more very fine grooves (9; 29) with a depth of more than 6 µm engraved in the substrate;
- the said groove or grooves (9; 29) being completely filled by at least two superimposed components:
• the first, situated at the bottom of the groove, consisting of a highly conductive material, namely either a conducting wire (17) or a conducting section, or a conducting substance produced by treatment of a liquid, powdery or pastelike precursor material (10) previously positioned in the groove, the said treatment having imparted to the said precursor material (10) its solid consistency and its final properties;
• the second, which seals the groove, being produced by treatment of a liquid, powdery or pastelike precursor material (11), which may or may not be conducting, the said treatment having imparted to the said precursor material (11) its solid consistency and its final properties;
- the conducting layer (7; 27) being deposited in such a way that it is in contact with the conducting component(s) positioned in the groove (9; 29) before filling, at an intermediate stage, or after the sealing of the groove.

2. Electrical circuit according to Claim 1, characterized in that the lateral to vertical engraving ratio of the groove (or grooves) (9; 29) is less than 1:1.

3. Electrical circuit according to one of Claims 1 and 2, characterized in that the depth of the grooves (9; 29) is greater than 15 µm.

4. Electrical circuit according to one of Claims 1 to 3, characterized in that the conducting wires (17) comprise a conducting protective coating (18), the said coating (18) possibly having undergone, after the positioning of the wire (17), a treatment which has consolidated it and given it its final properties.

5. Electrical circuit according to one of Claims 1 to 4, characterized in that a precursor material (10-11) introduced into the groove or grooves (9; 29), either at the bottom or as the sealing material, has been brought into its final form by fusion to reconstitute the analogue of a metal wire, by a heat treatment by microwaves or infrared radiation in the case of a metal powder or a metal powder made into a paste with water or conducting ink; by drying in the case of a paste or ink of the type used in screen printing or of the type filled with carbon or in the case of a conducting adhesive, for the purpose of evaporating the water or solvent contained therein; or by polymerization or setting in the case of polymerizable compounds or thermosetting polymer compounds.

6. Electrical circuit according to one of Claims 1 to 5, characterized in that the conducting part (3; 23) consists of at least one conducting substance (10-11-17-18; 28) applied in the groove or grooves (9; 29) without forming a relief on the surface of the substrate (2; 22) and a continuous or discontinuous conducting layer (7; 27) deposited on the substrate, the conductor or conductors filling the groove or grooves being disposed to form supplementary means (8 ; 28) for supplying current to the conducting layer (7; 27), means being provided to ensure electrical communication between the said layer (7; 27) and the supplementary current supply means (8; 28).

7. Electrical circuit according to Claim 6, characterized in that the means providing the electrical communication between the conducting layer (7; 27) and the supplementary current supply means (8; 28) consist of an extension of the said conducting layer (7; 27) on the internal wall of the groove (9; 29), within the conducting part located in the groove (9; 29), or on the upper surface of the said conducting part located in the groove (9; 29).

8. Electrical circuit according to Claim 6, characterized in that the means providing the electrical communication between the conducting layer (7) and the supplementary current supply means (8) consist of conducting strips (16) disposed in such a way that they link the conducting layer (7) and the upper surface of the conducting part located in the groove (9).

9. Electrical circuit according to one of Claims 6 to 8, characterized in that the conducting layer (7; 27) is discontinuous, the discontinuity being created by a deposition of the layer (27) in discontinuous parts, or by notches (13) or channels (14) made in the substrate (2) through the said layer or on one of the upper edges of the grooves (9), in such a way as to expose the insulating material constituting the substrate (2), the said notches (13) or channels (14) possibly being filled with a non-conducting material (15) restoring the surface continuity of the said substrate (2).

10. Electrical circuit according to one of Claims 1 to 9, characterized in that the substrate (2; 22) is a flat substrate and the grooves (9; 29) are grooves disposed in such a way that they are rectilinear and parallel to each other and interacting with a conducting layer (7; 27) which coats the substrate and is continuous or in the form of strips parallel to the grooves, at least one groove possibly being associated with one strip.

11. Process of fabrication of an electrical circuit as specified in one of Claims 1 to 10, characterized in that:
- the groove of grooves (9; 29) are engraved, according to the chosen circuit layout, in the surface of a substrate (2; 22) made of insulating material, coated if necessary with a thin conducting layer (12), with possible subsequent deposition of a thin layer of conducting material on the parts or on the whole of the surface of the substrate, including grooves, if the said substrate has not been previously coated;
- the grooves are filled by the introduction of at least one layer of precursor material of the conducting layer (10, 11; 28), which may be a dust or having a liquid to paste-like consistency, appropriate for being applied in the said grooves, and/or by the direct positioning of a conducting wire (17) which may be provided with a conducting coating, or of a conducting section, the filling being completed if necessary by a layer of material in the form of dust or having a liquid to paste-like consistency, which is the precursor of a conducting or non-conducting protective layer which is neutral with respect to its environment;
- after the positioning of at least one precursor material, this material is appropriately treated to give it its final shape, consistency and properties, a thin layer of conducting material, in the case of a previously uncoated substrate, possibly being deposited during the filling of the grooves, on parts or all of the substrate, including grooves, between two layers of filling of the grooves, or deposited after the filling of the grooves on parts or all of the substrate; and
- in the case in which the external thin layer has to be discontinuous, notches (13) or channels (14) are formed in such a way as to expose the substrate of insulating material, according to the chosen circuit layout, the notches or channels possibly being filled subsequently by a non-conducting material (15).

12. Process according to Claim 11, characterized in that the grooves are formed by laser etching, pressing, injection, upsetting, sandblasting, lapping, grinding, high-pressure water jet, ultrasonic machining or erosion.

13. Process according to Claim 11, characterized in that the successive layers of precursor material are applied by application of a powdery substance or one having a liquid to pastelike consistency in the precursor material to the substrate surface bearing the grooves and the removal of the substance which has not penetrated into the grooves, or by application of a paste or ink with a squeegee or with an inking roller, possibly after the execution, before the formation of the grooves, of a treatment designed to make the substrate surface non-wettable by the ink, so that the applied ink flows virtually exclusively into the grooves.

14. Process according to Claim 11, characterized in that the precursor material positioned in a groove is given its final shape and/or structure by fusion to reconstitute the analogue of a metal wire by heat treatment by microwaves or infrared radiation, in the case of a metal powder or a metal powder made into a paste with water or a conducting ink; by drying in the case of a paste or ink of the type used in screen printing or of the type filled with carbon or a conducting adhesive, by the evaporation of the water or solvent contained in it; or by polymerization or setting in the case of polymerizable compounds or thermosetting polymer compounds.

15. Device comprising at least one electrical circuit as specified in one of Claims 1 to 10, or fabricated by the process as specified in one of Claim 11 to 14.

16. Device according to Claim 15 for the modulation of light or display, such as an electroluminescent, electrochromic or liquid crystal device or a device of the type of glazing or a valve with variable optical properties, comprising two substrates of which one carries a circuit of electrodes and the other a circuit of counter electrodes, the two circuits being disposed facing each other with the interposition of a luminophore layer, characterized in that at least one of the two electrode circuits is as specified in one of Claims 1 to 10, or fabricated by the process as specified in one of Claims 11 to 14.

17. Device according to Claim 16, consisting of a screen or display unit consisting of cells operated in a matrix mode, the circuits of electrodes and counter electrodes consisting respectively of parallel conducting columns and parallel conducting lines, disposed perpendicularly to the columns, characterized in that at least the electrode circuit is a circuit as specified in Claim 10.

18. Device according to Claim 16, consisting of glazing or valves with variable properties, characterized in that both circuits are as specified in one of Claims 1 to 10, with the possibility of providing means to ensure the independent control of the potential of the conducting parts of each groove and, if necessary, of the external conducting layer associated with the groove, if this layer is discontinuous.
